# EUROPEAN PATENT SPECIFICATION

(11) **EP 2 147 568 B1**
(45) Date of publication and mention of the grant of the patent: **04.01.2017**
(21) Application number: 08724173.3
(22) Date of filing: 10.04.2008
(51) Int. Cl.: H04R 5/033, H03G 3/30, G10K 11/00, H04R 1/10, H04R 25/00, H03G 7/00

(54) **A METHOD AND AN APPARATUS FOR DAMPING AN AUDIO SIGNAL**
VERFAHREN UND VORRICHTUNG ZUM DÄMPFEN EINES AUDIOSIGNALS
PROCÉDÉ ET APPAREIL D'AMORTISSEMENT D'UN SIGNAL AUDIO

(30) Priority: 07.05.2007 SE 0701101
(43) Date of publication of application: 27.01.2010
(73) Proprietor: 3M Innovative Properties Company, St. Paul, MN 55133-3427 (US)
(72) Inventor: KIHLBERG, Roger, S-331 91 Värnamo (SE); KAREKULL, Oscar, S-553 334 Jonkoping (SE)
(74) Representative: Herzog, Fiesser & Partner Patentanwälte PartG mbB
(86) International application number: PCT/SE2008/000260
(87) International publication number: WO 2008/136723

(56) References cited:
- EP-A2- 1 558 059
- WO-A2-02/07480
- GB-A- 2 120 903
- SE-A- 7 614 482
- US-A- 4 538 296
- US-A- 5 701 352
- US-A1- 2003 223 612
- US-A1- 2004 131 214

## Description

### TECHNICAL FIELD

The present invention relates to a method for limiting the sound volume in an earphone, a headset, or the like, to a maximum permitted level, comprising the steps that an input signal to the earphone, the headset etc., is sensed by a processor, and that, at an excessively high level of the input signal, the signal is damped by a damper before being transmitted further to the earphone, the headset, etc.

The present invention also relates to an apparatus for limiting the sound volume in an earphone, a headset, or the like, applying the above method.

### BACKGROUND ART

The use of portable music playing devices, such as for example CD-and MP3 players and the like is becoming increasingly common. As a result, it has been found that the risk of hearing injury increases, since it is far too easy to increase the sound volume to a level which risks injuring the hearing of the user. Not least, this is the case when the sound volume is increased so as overcome ambient noise, for example traffic noise.

In order to reduce disturbances from ambient noise or sound, certain earphones are formed as sealing plugs, which exclude airborne sound from the ambient environment, but where the sound from the music player is allowed passage. The drawback in this feature is that the effect from the sound signal is concentrated to the eardrum, since the sonic waves from the earphone cannot propagate outwards, in a direction away from the ear of the user. With this type of earphone, the risk of injury to the hearing is particularly manifest.

For some time, increasingly stringent requirements have begun to be placed on a limitation of sound levels, in order to avoid the occurrence of sound levels that are harmful to the auditory system. Those attempts that have been made have generally entailed providing the music players with some type of software which limits the outgoing sonic signal from the player.

In certain cases, this solution could function well, but unfortunately suffers from certain drawbacks. Often, the software can be disengaged by the user if the user is not satisfied with the sonic signal obtained. Such users are often children or youngsters who are well aware of how the music players can be operated, but do not realise the consequences of exposing themselves to excessively high sound levels. Most generally, their parents have no control over how the software of the music player is manipulated.

Another drawback is that one and the same output signal from a music player can give totally different sound volumes in the ears of the user, depending on the type of earphone employed. Thus, if the player is used with those earphones or headsets which are supplied as standard on purchase, the sound levels may be completely safe and acceptable. However, if the earphone or headset is replaced, either because it is experienced as being insufficient by the user or because of some type of defect and must be replaced, the results can be totally different. The sonic signal to which the listener's ears is exposed can at once amount to unsuitable or quite simply harmful levels. Thus, it is suitable if the damping feature is adapted to the earphone or headset and is connected to it.

Certain types of digital signal processing have been tried where the signal passes through a processor before reaching the earphone. One drawback is that power consumption is relatively high, which implies either that the batteries that are used in the player quickly need recharging or replacing, or that the earphones must be provided with separate batteries. Another drawback is that the sound quality is affected, which is of major importance in listening to music. However, there are occasions when sound quality is of lesser importance, for example when the earphones are principally used to transmit the spoken word and similar short messages, as is, for instance, the case in certain types of hearing protection.

US 2003/0223612 A1 discloses an earmuff comprising a headpiece and a circuit including a digital potentiometer and a microcontroller.

### PROBLEM STRUCTURE

Thus, it is the object of the present invention to maximise the sound quality obtained in an earphone, a headset, or the like, at the same time as power consumption is minimised and a reliable damping to a safe sound level is obtained.

### SOLUTION

The invention is defined by the appended claims.

The objects forming the basis of the present invention will be attained regarding the method if this is characterised in that the processor switches between a state where it is in active mode and a state where it is in a passive or rest mode.

Concerning the apparatus, the objects of the present invention will be attained if the apparatus is characterised in that it comprises a microprocessor and a damper.

Further advantages will be attained if the present invention is moreover characterised by any one or more of the characterising features as set forth in appended Claims 2 to 8 and 10 to 12, respectively.

### BRIEF DESCRIPTION OF THE ACCOMPANYING DRAWINGS

The present invention will now be described in greater detail hereinbelow, with reference to the accompanying Drawings. In the accompanying Drawings:
- Fig. 1: is a block diagram of the apparatus according to the present invention in broad outline;
- Fig. 2: is a block diagram of the microprocessor included in the apparatus;
- Fig. 3: is a block diagram of the method according to the present invention in broad outline; and
- Fig. 4: is a block diagram of the active mode included in the method.

### DESCRIPTION OF PREFERRED EMBODIMENT

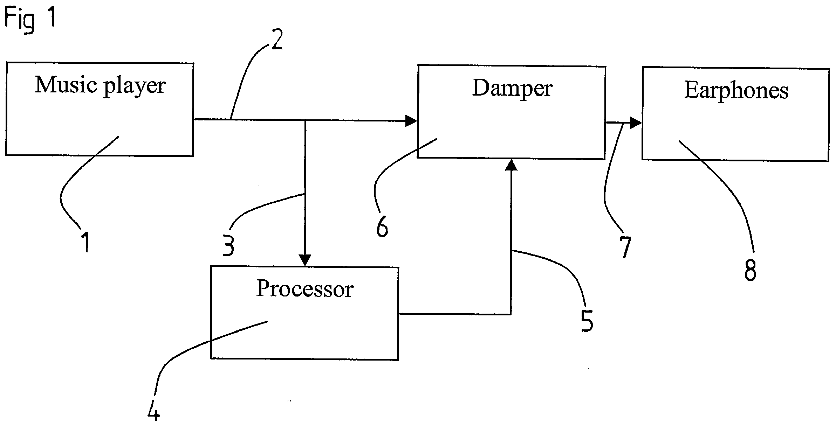

Referring to the Drawings, Fig.1 shows in broad outline the apparatus according to the invention for damping a sonic signal 2 from a music player 1 before it reaches the listener's ears.

The music player 1, which may be a CD player, an MP3 player or some other type of music player, emits a sonic signal 2 which functions as an input signal to the damping device according to the invention, this damping device being physically connected to earphones 8, and cannot be permanently disconnected therefrom. When the input signal 2 exceeds a predetermined level, it will be damped by a damper 6 before being transmitted further to the earphones 8 in the form of an output signal 7 from the apparatus. The damper 6 is controlled by means of a control signal 5 which derives from a microprocessor 4. The microprocessor 4 senses the input signal 2 with the aid of a sampling signal 3, which constitutes an extremely small part of the input signal 2, but which is nevertheless sufficient to determine the sound level of the input signal 2. The sensing takes place in the order of magnitude of 100 times/s., which implies that the microprocessor 4 is not utilised to its full capacity for the greater part of the time.

The damper 6 is a per se previously known component, but it requires a control signal 5 produced in a suitable manner to be able to emit an output signal 7 which does not exceed the maximum desired sound level.

The microprocessor 4 is similarly a standard component with low energy consumption, but if it is disposed according to the invention and driven according to the invention together with the damper 6, the result will be an energy miser sound damping with maintained sound quality. It is even possible to expect that the apparatus requires such little energy that it can be driven using one and the same battery throughout its entire service life.

For this to be possible to achieve, the microprocessor 4 and the damper 6 are, in the preferred embodiment, connected in parallel to one another so that the sonic signal 2 which is to be damped is not led straight through the microprocessor 4, but is led directly to the damper 6 which is controlled digitally by the microprocessor 4 based on a sampling 3, i.e. a sensing of the input signal 2.

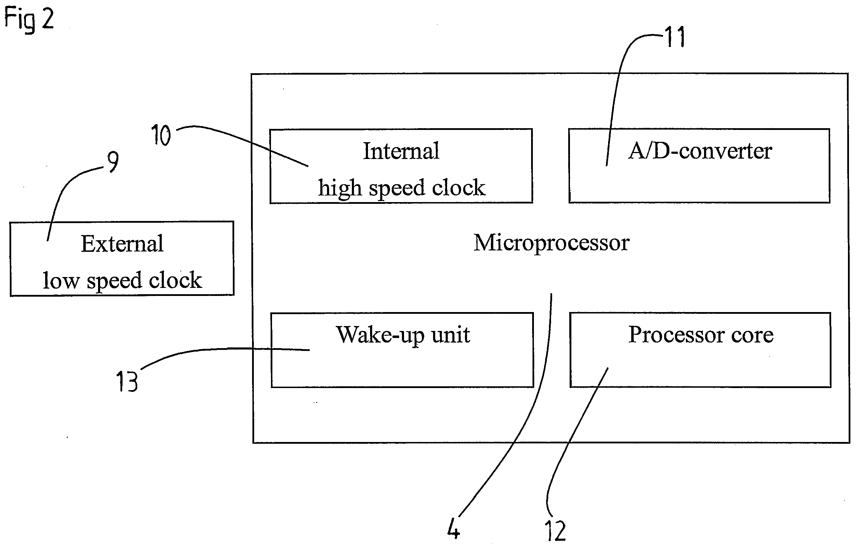

Fig. 2 shows the microprocessor 4 schematically with several details. The microprocessor 4 is a standard component, implying that it displays a number of different functions, of which not all are employed in the practical application of the present invention. Those functions that are not utilised have been omitted from Fig. 2. The microprocessor 4 has an external low speed clock 9 which is used in the sampling 3 of the input signal 2. In the present invention, it has in practice proved to function with a frequency of 400 kHz, the current consumption being .003mA.

An internal high speed clock 10 is used on calculations and the like in the microprocessor 4. Its frequency is, in practical applications, about 8 MHz, which implies that it is not possible to use this clock 10 on sampling 3, since the frequency is far too high for sampling a sonic signal.

An A/D converter 11 is employed for reading the input signal 2 from the music player 1, i.e. on the sampling 3 of the input signal 2. It is thus the A/D converter 11 that directly senses the analog input signal 2 and converts the sensed signal to a digital value, while the external low speed clock 9 determines at which rate this is to take place.

In the core 12 of the microprocessor those calculations take place that are necessary on processing of the sampling 3 of the input signal 2, for generating the control signal 5 to the damper 6. The calculation takes place at the speed of the internal high speed clock 10.

Further, there is at least one wake-up unit 13 which, on the one hand, can realise a periodic waking-up from a rest or passive mode of the microprocessor 4 roughly twice/s so that a new sampling series 3 can be taken up. The wake-up unit or units 13 can also realise a waking-up of the microprocessor 4 on an external impulse, e.g. a button push. This takes place when the microprocessor 4 has entered into a rest mode after a lengthy period of silence, i.e. the absence of an input signal 2.

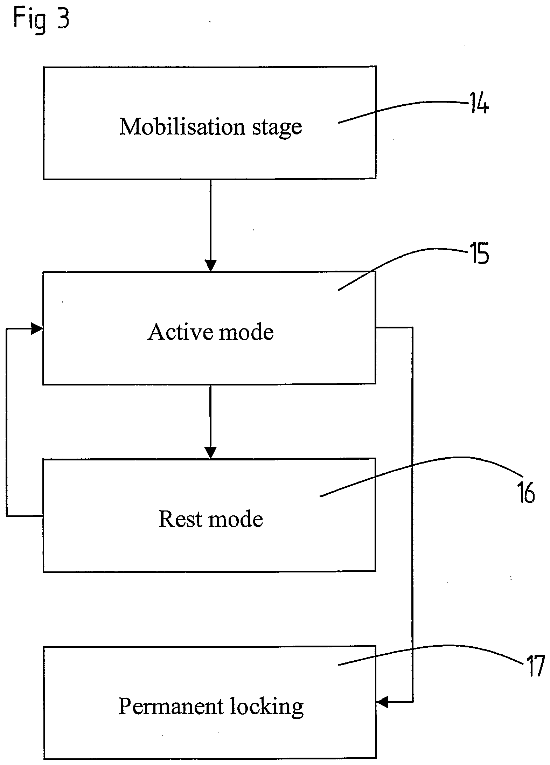

Fig. 3 shows a block diagram of the broad features in the method for sound damping according to the present invention.

In broad outlines, there are four different steps in the method. Initially, the method undergoes a mobilisation or start-up stage 14 where all hardware is installed and the software initiated, so that the method can switch between different modes throughout the entire operational life of the apparatus. Thus, the mobilisation stage 14 need only be completed once during the operational life of the product.

When the initiation has been completed and the different clocks 9 and 10 have been started, the process can enter into the next stage, the active mode 15. In the active mode 15, a sampling 3 is undertaken at regular intervals in time, and from the sampling 3 a mean sound level is calculated so that damping can be put into effect. Now and then, a check is made to ensure whether the battery voltage is sufficient in that battery which drives all of the hardware. In order to save the battery as much as possible, and thereby prolong its service life, operation is not continuous, but the process enters into temporary, energy-saving rest modes, on the one hand between the series of samplings and the mean value calculations and, on the other hand, when the incoming input signal 2 is so low that no damping thereof is necessary.

A more lengthy rest mode 16 is attained after the sampling 3 has not shown any input signal during the last 2-4 hours, i.e. in the event of silence when the music player 1 is not in use. In order for the process to revert to the active mode 15 from the rest mode 16 and the clocks 9, 10 once again be started, an external signal is required in the form of a button push. Essentially, it is the detection of the button push operation which is the only function remaining during the rest mode 16.

As was mentioned above, the battery voltage is checked at regular intervals, battery interval t_{b}, in the active mode 15. When the battery is considered to be dead, in that an excessively low battery voltage has been recorded on a predetermined number of occasions, the process moves into a state of permanent locking 17, from which it cannot return, and the damping device must then be considered as consumed.

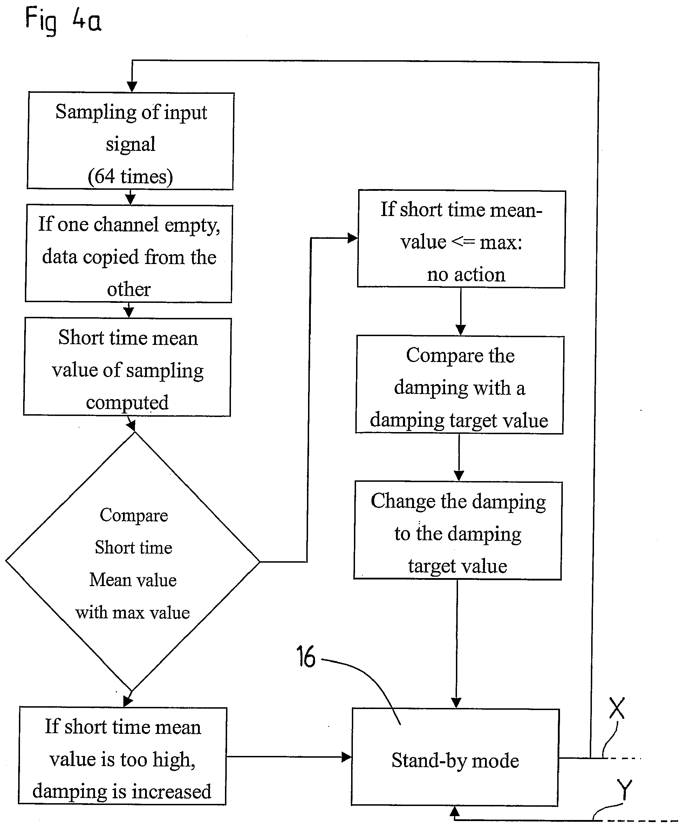

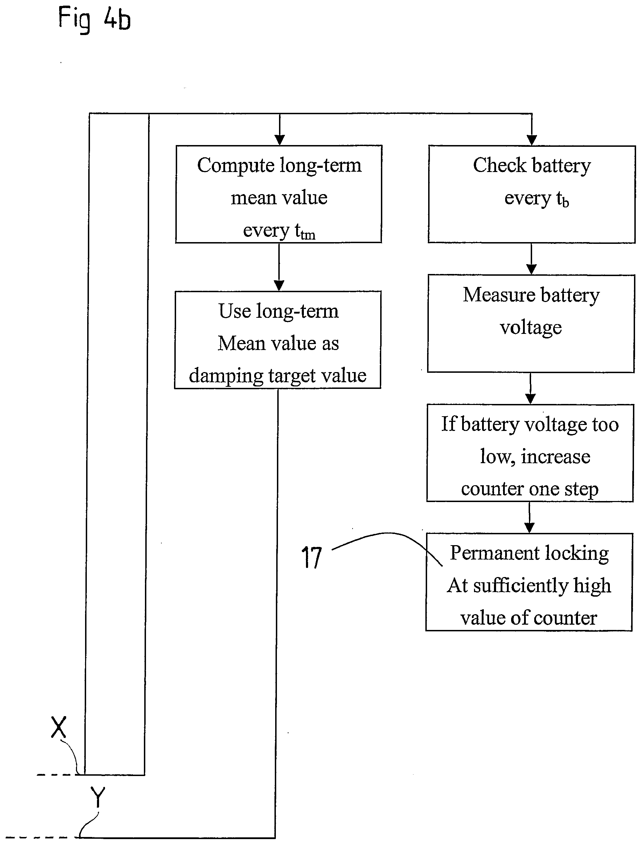

Fig. 4 shows a block diagram of the active mode 15 with additional details therein. In sequence, in the active mode 15, there is first a sampling of the input signal 2, which is typically divided in two channels, one for the left and one for the right earplug, respectively. The sampling takes place alternatingly between these two channels. The sampling is repeated 64 times in the preferred embodiment and takes place at the speed of the external low speed clock 9.

Thereafter, a data processing of the sampled data takes place. If any of the right or left channels shows a zero value, data is copied from the other channel, so that two complete channels are obtained. A mean value of the sampled data is calculated, and since the sampling takes place during a limited time, this is a short time mean value. In the next stage, a comparison is made between the mean value and the maximum permitted value, and if the mean value exceeds the maximum permitted value, a control signal 5 is transmitted to the damper 6 to immediately increase the damping, whereafter the processor 4 can go into an energy-saving mode until the next sampling. If on the other hand the mean value is less than the permitted maximum value, no immediate increase is needed, but the damping is compared with a damping target value and can be changed to a long-term mean value, which is based on the results of a plurality of samplings 3, at a fixed change speed. The long-term mean value is calculated with the time interval tₜₘ, long-term interval.

Every battery interval, roughly once an hour, a check is made of the battery voltage, as mentioned above. This part of the process entails that the battery voltage is measured and compared with a least permitted value. If the value is found to be exceedingly low, this fact is registered and when an excessively low value of the battery voltage is registered on a number of occasions, so that it is absolutely certain that the battery is genuinely about to die, the process enters into the mode of permanent locking 17. From this mode 17, the process cannot return and the damping device and its associated earphone or headset is thereby consumed.

### DESCRIPTION OF ALTERNATIVE EMBODIMENTS

Conceivably, one or more of the features in the above-described embodiment of the present invention can be modified. For example, it is conceivable that the locking when the battery is dead is not made permanent, but that this can be remedied by a battery replacement, which implies that the process then restarts from its initial stage 14. Another method of modifying the present invention is that the speeds of the clocks 9 and 10, for example on the calculation or the sampling, can be adjusted. However, it must be ensured that, after the adjustment, the apparatus is still within that range which functions in this particular application. For example, the sampling frequency may not be higher than that it is still possible to sample sound frequencies within the audible range. Other examples of variations are that the time between two checks of the battery voltage is varied, that the time of absence of input signal before the lengthy rest mode 16 is attained is changed and that the time interval between different sampling series is varied.

## Claims

1. A method for limiting the sound volume in an earphone (8) or a headset to a maximum permitted level, comprising the steps that an input signal (2) to the earphone or the headset is sensed by a microprocessor (4), and that, at an excessively high level of the input signal (2), the signal is damped by a damper (6) before being transmitted further to the earphone (8) or the headset, **characterised in that** the microprocessor (4) switches between a state where it is in an active mode (15) and a state where it is in a rest mode (16), wherein in the active mode, the input signal (2) is periodically sampled, a mean value is calculated, a comparison is made with the maximum permitted level, and a correct damping is set, whereafter the microprocessor (4) can go into an energy-saving mode until the next sampling.

2. The method as claimed in Claim 1, **characterised by** an initial mobilisation or start-up stage (14).

3. The method as claimed in Claim 1 or 2, **characterised in that** the method is terminated by the microprocessor to a permanent locking state (17).

4. The method as claimed in any of Claims 1 to 3, **characterised in that**, after a lengthy period of absence of an input signal (2), the microprocessor (4) switches to the rest mode (16) from the active mode (15).

5. The method as claimed in any of Claims 1 to 4, **characterised in that**, on an externally arriving impulse, the microprocessor (4) switches to the active mode (15) from the rest mode (16).

6. The method as claimed in Claim 3, **characterised in that** the battery voltage is measured periodically and that after a predetermined number of excessively low voltage measurements, the microprocessor switches to the permanent locking state (17).

7. The method as claimed in any of Claims 1 to 6, **characterised in that** when the input signal (2) is sufficiently low that no damping is necessary, the microprocessor (4) switches to an energy saving mode.

8. The method as claimed in any of Claims 1 to 7, **characterised in that** the sensing takes place in the active mode (15) of the microprocessor (4).

9. An apparatus configured to limit the sound volume in an earphone (8) or a headset by means of the method as claimed in any of Claims 1 to 8, **characterised in that** the apparatus includes a microprocessor (4) and a damper (6).

10. The apparatus as claimed in Claim 9, **characterised in that** the microprocessor (4) is connected in parallel with the damper (6).

11. The apparatus as claimed in Claim 9 or 10, **characterised in that** the microprocessor (4) includes a high speed clock (10) for processing sensed data (3) from the input signal (2).

12. The apparatus as claimed in any of Claims 9 to 11, **characterised in that** an external low speed clock (9) is disposed outside the microprocessor (4) for controlling the speed for sensing of data from the input signal (2).

## Patentansprüche

1. Verfahren zum Begrenzen der Lautstärke in einem Ohrhörer (8) oder einem Kopfhörer auf ein maximal zugelassenes Niveau, umfassend die Schritte, dass ein Eingangssignal (2) zum Ohrhörer oder Kopfhörer durch einen Mikroprozessor (4) erfasst wird, und dass bei einem übermäßig hohen Niveau des Eingangssignals (2) das Signal durch einen Dämpfer (6) gedämpft wird, bevor es zum Ohrhörer (8) oder Kopfhörer übertragen wird, **dadurch gekennzeichnet, dass** der Mikroprozessor periodisch (4) zwischen einem Zustand, in dem er sich in einem aktiven Modus (15) befindet, und einem Zustand umschaltet, in dem er sich in einem Ruhemodus (16) befindet, wobei im aktiven Modus das Eingangssignal (2) periodisch geprüft wird, ein Mittelwert berechnet wird, ein Vergleich mit dem maximal zugelassenen Niveau vorgenommen wird und eine korrekte Dämpfung eingestellt wird, wonach der Mikroprozessor (4) bis zum nächsten Schaltvorgang in einen temporären energiesparenden Ruhezustand eintritt.

2. Verfahren nach Anspruch 1, **gekennzeichnet durch** ein anfängliches Mobilisations- oder Anlaufstadium (14).

3. Verfahren nach Anspruch 1 oder 2, **dadurch gekennzeichnet, dass** das Verfahren durch den Mikroprozessor mit einem permanenten Verriegelungszustand (17) beendet wird.

4. Verfahren nach einem der Ansprüche 1 bis 3, **dadurch gekennzeichnet, dass** der Mikroprozessor (4) nach einer längeren Abwesenheitsperiode eines Eingangssignals (2) vom aktiven Modus (15) in den Ruhemodus (16) umschaltet.

5. Verfahren nach einem der Ansprüche 1 bis 4, **dadurch gekennzeichnet, dass** durch einen von außen ankommenden Impuls der Mikroprozessor (4) vom Ruhemodus (16) in den aktiven Modus (15) umschaltet.

6. Verfahren nach Anspruch 3, **dadurch gekennzeichnet, dass** die Batteriespannung periodisch gemessen wird, und dass der Mikroprozessor nach einer vorgegebenen Anzahl von Messungen übermäßig geringer Spannungen in den permanenten Verriegelungszustand (17) umschaltet.

7. Verfahren nach einem der Ansprüche 1 bis 6, **dadurch gekennzeichnet, dass** der Mikroprozessor (4) in einen energiesparenden Modus umschaltet, wenn das Eingangssignal (2) ausreichend niedrig ist, damit kein Dämpfen notwendig ist.

8. Verfahren nach einem der Ansprüche 1 bis 7, **dadurch gekennzeichnet, dass** das Erfassen im aktiven Modus (15) des Mikroprozessors (4) stattfindet.

9. Vorrichtung, gestaltet zum Begrenzen der Lautstärke in einem Ohrhörer (8) oder einem Kopfhörer durch das Verfahren nach einem der Ansprüche 1 bis 8, **dadurch gekennzeichnet, dass** die Vorrichtung einen Mikroprozessor (4) und einen Dämpfer (6) aufweist.

10. Vorrichtung nach Anspruch 9, **dadurch gekennzeichnet, dass** der Mikroprozessor (4) zum Dämpfer (6) parallel geschaltet ist.

11. Vorrichtung nach Anspruch 9 oder 10, **dadurch gekennzeichnet, dass** der Mikroprozessor (4) einen Hochgeschwindigkeitstakt (10) zum Verarbeiten erfasster Daten (3) aus dem Eingangssignal (2) aufweist.

12. Vorrichtung nach einem der Ansprüche 9 bis 11, **dadurch gekennzeichnet, dass** ein externer Niedriggeschwindigkeitstakt (9) außerhalb des Mikroprozessors (4) zum Steuern der Geschwindigkeit des Erfassens von Daten aus dem Eingangssignal (2) angeordnet ist.

## Revendications

1. Procédé de limitation du volume sonore dans un écouteur (8) ou un casque d'écoute à un niveau maximal autorisé, comprenant les étapes selon lesquelles un signal d'entrée (2) vers l'écouteur ou le casque d'écoute est détecté par un microprocesseur (4) et, à un niveau excessivement élevé du signal d'entrée (2), le signal est atténué par un atténuateur (6) avant d'être transmis plus loin vers l'écouteur (8) ou le casque d'écoute, **caractérisé en ce que** le microprocesseur passe (4) d'un état où il est dans un mode actif (15) à un état où il est dans un mode de repos (16), dans lequel, dans le mode actif, le signal d'entrée (2) est périodiquement échantillonné, une valeur moyenne est calculée, une comparaison est faite avec le niveau maximal autorisé et une atténuation correcte est établie, après quoi le microprocesseur (4) peut entrer dans un mode d'économie d'énergie, jusqu'à l'échantillonnage suivant.

2. Procédé selon la revendication 1, **caractérisé par** une mobilisation initiale ou phase de démarrage (14).

3. Procédé selon la revendication 1 ou 2, **caractérisé en ce que** le procédé est terminé par le microprocesseur à un état de verrouillage permanent (17).

4. Procédé selon l'une quelconque des revendications 1 à 3, **caractérisé en ce qu'**après une longue période d'absence d'un signal d'entrée (2), le microprocesseur (4) passe au mode de repos (16) depuis le mode actif (15).

5. Procédé selon l'une quelconque des revendications 1 à 4, **caractérisé en ce qu'**en cas d'impulsion arrivant de l'extérieur, le microprocesseur (4) passe au mode actif (15) depuis le mode de repos (16).

6. Procédé selon la revendication 3, **caractérisé en ce que** la tension de batterie est mesurée périodiquement et qu'après un nombre prédéfini de mesures de tension excessivement basses, le microprocesseur passe à l'état de verrouillage permanent (17).

7. Procédé selon l'une quelconque des revendications 1 à 6, **caractérisé en ce que**, lorsque le signal d'entrée (2) est suffisamment bas et qu'aucune atténuation n'est nécessaire, le microprocesseur (4) passe à un mode d'économie d'énergie.

8. Procédé selon l'une quelconque des revendications 1 à 7, **caractérisé en ce que** la détection se déroule dans le mode actif (15) du microprocesseur (4).

9. Appareil conçu pour limiter le volume sonore dans un écouteur (8) ou un casque d'écoute au moyen du procédé selon l'une quelconque des revendications 1 à 8, **caractérisé en ce que** l'appareil inclut un microprocesseur (4) et un atténuateur (6).

10. Appareil selon la revendication 9, **caractérisé en ce que** le microprocesseur (4) est connecté en parallèle avec l'atténuateur (6).

11. Appareil selon la revendication 9 ou 10, **caractérisé en ce que** le microprocesseur (4) inclut une horloge à grande vitesse (10) pour le traitement des données détectées (3) du signal d'entrée (2).

12. Appareil selon l'une quelconque des revendications 9 à 11, **caractérisé en ce qu'**une horloge externe à faible vitesse (9) est disposée à l'extérieur du microprocesseur (4) pour commander la vitesse de détection de données du signal d'entrée (2).
